# EUROPEAN PATENT APPLICATION

(11) **EP 4 501 833 A1**
(43) Date of publication of application: **05.02.2025**
(21) Application number: 24764128.5
(22) Date of filing: 21.02.2024
(51) Int. Cl.: B66B 5/00, G06Q 50/10

(54) **MAINTENANCE SYSTEM FOR PASSENGER TRANSPORT EQUIPMENT**

(30) Priority: 27.02.2023 KR 20230026045; 02.11.2023 KR 20230150052
(71) Applicant: Hyundai Elevator Co., Ltd., Chungju-si, Chungcheongbuk-do (KR)
(72) Inventor: YOUN, Suk Jun, Chungju-si, Chungcheongbuk-do 27329 (KR); KUM, In Soo, Chungju-si, Chungcheongbuk-do 27329 (KR)
(74) Representative: Baldus, Oliver
(86) International application number: PCT/KR2024/002274
(87) International publication number: WO 2024/181728

(57) **Abstract**

The present invention relates to a maintenance system for passenger transport equipment and provides a maintenance system for passenger transport equipment, the maintenance system comprising: a maintenance terminal that is carried by a maintenance worker and configured to input a failure processing result comprising a failed part and error code information after completing failure processing; and a failure diagnosis server that collects and stores the failure processing result input from the maintenance terminal, and predicts a failure part that may fail in the future and a point in time of occurrence of a failure by applying the stored failure processing result together with failure occurrence time information to a machine learning model, wherein the maintenance terminal receives a transmission of the result of the prediction of the failure from the failure diagnosis server and displays the result of the prediction of the failure.

## Description

### [Technical Field]

The present invention relates to a maintenance management system for passenger transport equipment, which can predict future failure.

### [Background Art]

In various high-rise buildings for residential and business purposes, elevators are installed to facilitate vertical movement of passengers visiting such buildings.

An elevator includes an elevator car that moves passengers while moving up and down along a hoistway formed in a building in a vertical direction, a mechanical part provided with a motor and a winding machine to generate a predetermined power to move the elevator car to a corresponding floor in response to a button operation of a passenger, and an elevator controller that controls the mechanical part in response to the button operation of the passenger such that the elevator car can be smoothly and stably operated.

On the other hand, even when failure can be remotely diagnosed upon occurrence of the failure in an elevator, an elevator maintenance worker can be dispatched to a work site to repair the failure after the failure has occurred, meaning that passengers cannot use the elevator during maintenance work. Especially in today's skyscraper environment, even a short period of downtime can be very inconvenient for users and thus prediction of failure in an elevator is a very important issue.

Accordingly, in recent years, there has been active research and development of a predictive maintenance technology capable of predicting failure of an elevator.

The predictive maintenance technology refers to a technique that collects operation data of an elevator and predicts failure occurrence through training, such as machine learning, based on the collected operation data, and is very important since this technique can prevent interruption in operation due to failure of the elevator and can minimize maintenance time.

However, current predictive preservation technologies are not widely used due to their low accuracy and there is an urgent need to develop technologies for improvement in prediction accuracy.

(Prior art Reference) Korean Patent Registration No. 10-1775529

### [Disclosure]

### [Technical Problem]

It is an aspect of the present invention to provide a maintenance system for passenger transport equipment that can accurately predict possible future failure based on past failure history data.

### [Technical Solution]

In accordance with one aspect of the present invention, there is provided a maintenance system for passenger transport equipment, including: a maintenance terminal carried by a maintenance worker and configured to input failure treatment results including faulty component and error code data after completion of failure treatment; and a failure diagnosis server configured to collect and store the failure treatment results input from the maintenance terminal and configured to predict a possible future faulty component and a future failure occurrence time through application of the stored failure treatment results together with failure occurrence time data to a machine learning model, wherein the maintenance terminal is configured to receive and display a failure prediction result sent from the failure diagnosis server.

The failure diagnosis server may include: a treatment result storage unit configured to collect and store the failure treatment results together with the failure occurrence time data; and a calculation unit configured to predict the possible future faulty component and the future failure occurrence time through application of the faulty component and error code data of the failure treatment results and failure occurrence time data of each faulty component to the machine learning model.

The treatment result storage unit may be configured to classify the failure treatment results collected from the maintenance terminal for each faulty component and configured to sequentially store the failure treatment results in a time sequence of failure occurrence, and the calculation unit may be configured to calculate a failure occurrence time interval for each faulty component stored in the treatment result storage unit and configured to predict a future failure occurrence time for each faulty component through application of each faulty component and error code data and the failure occurrence time interval for each faulty component to a machine learning model.

The failure diagnosis server may be configured to collect and store error code data of the passenger transport equipment from a control panel of the passenger transport equipment and configured to diagnose a failure cause based on the collected error code data, and the maintenance terminal may be configured to access the failure diagnosis server to receive and display the error code data and a diagnosis result of the failure cause sent from in the failure diagnosis server.

The failure diagnosis server may further include: an error code storage unit configured to arrange and store the error code data of the passenger transport equipment collected from the control panel of the passenger transport equipment in a time sequence and configured to classify the error code data into one time-series data group at every preset reference time interval to store the classified error code data; and a diagnosis unit configured to analyze the corresponding error code data for each time-series data group stored in the error code storage unit to diagnose a failure cause for the time-series data group, wherein the calculation unit is configured to predict the possible future faulty component and the future failure occurrence time by applying a faulty component, corresponding error code data and failure occurrence time data produced based on the diagnosis result of the diagnosis unit to a machine learning model.

The calculation unit may be configured to integrate a failure prediction result based on the failure treatment results of the maintenance terminal and a failure prediction result based on the diagnosis result of the diagnosis unit to produce a single failure prediction result with respect to the possible future faulty component and the future failure occurrence time.

In accordance with another aspect of the present invention, there is provided a method of controlling a maintenance system for passenger transport equipment, the maintenance system including a maintenance terminal and a failure diagnosis server, the method including: inputting failure treatment results including faulty component and error code data to the maintenance terminal; collecting and storing the failure treatment results input to the maintenance terminal through the failure diagnosis server; predicting a possible future faulty component and a failure occurrence time through the failure diagnosis server through application of the failure treatment results stored in the failure diagnosis server together with failure occurrence time data to a machine learning model; and receiving and displaying a failure prediction result of the failure diagnosis server through the maintenance terminal.

The step of collecting and storing through the failure diagnosis server may include: collecting the failure treatment results from the maintenance terminal; and classifying the collected failure treatment results for each faulty component to sequentially store the failure treatment results in a time sequence of failure occurrence; and the step of predicting through the failure diagnosis server may include: calculating a failure occurrence time interval for each faulty component stored in the failure diagnosis server; and predicting a future failure occurrence time for each faulty component by applying each faulty component, the error code data and the failure occurrence time interval for each faulty component stored in the treatment result storage unit to a machine learning model.

### [Advantageous Effects]

According to the present invention, the maintenance system for passenger transport equipment can extract a failure occurrence time interval for each faulty component based on past failure history data and can predict a possible future failure occurrence time for each faulty component based on an extraction result.

In addition, the maintenance system can predict a possible future failure occurrence time to allow a maintenance worker to perform maintenance work before occurrence of failure, thereby improving user convenience and safety of the passenger transport equipment.

### [Description of Drawings]

FIG. 1 is a conceptual block diagram of an overall configuration of an elevator maintenance management system according to one embodiment of the present invention.
FIG. 2 is a conceptual block diagram of an overall configuration of an elevator maintenance management system according to another embodiment of the present invention.
FIG. 3 is a block diagram of a failure diagnosis server and a maintenance terminal of the elevator maintenance management system according to the embodiment of the present invention.
FIG. 4 and FIG. 5 are exemplary views illustrating a method of accessing a failure diagnosis server by the maintenance terminal and a method of displaying a failure diagnosis result in the elevator maintenance management system according to the embodiment of the present invention.
FIG. 6 is an exemplary view illustrating error code data displayed on the maintenance terminal according to the embodiment of the present invention.
FIG. 7 is an exemplary view illustrating a method of displaying failure diagnosis results in the maintenance terminal according to the embodiment of the present invention.
FIG. 8 is an exemplary view of a basic data input screen on a treatment result input screen of the maintenance terminal according to the embodiment of the present invention.
FIG. 9 shows exemplary views of a component selection input screen of a selection input screen of the treatment result input screen according to the embodiment of the present invention.
FIG. 10 shows exemplary views of an additional selection input screen of the selection input screen of the treatment result input screen according to the embodiment of the present invention.
FIG. 11 is an exemplary view of an error code selection input screen of the selection input screen of the treatment result input screen according to the embodiment of the present invention.
FIG. 12 is a flow diagram illustrating a method of predicting failure of an elevator maintenance system according to one embodiment of the present invention.

### [Best Mode]

Hereinafter, exemplary embodiments of the present invention will be described in detail with reference to the accompanying drawings. Like components will be denoted by like reference numerals throughout the drawings. In addition, detailed descriptions of known functions and constructions which may unnecessarily obscure the subject matter of the invention will be omitted.

First, a passenger transport device according to the present invention includes an elevator, an escalator, and a moving walkway. The following description will refer to elevators.

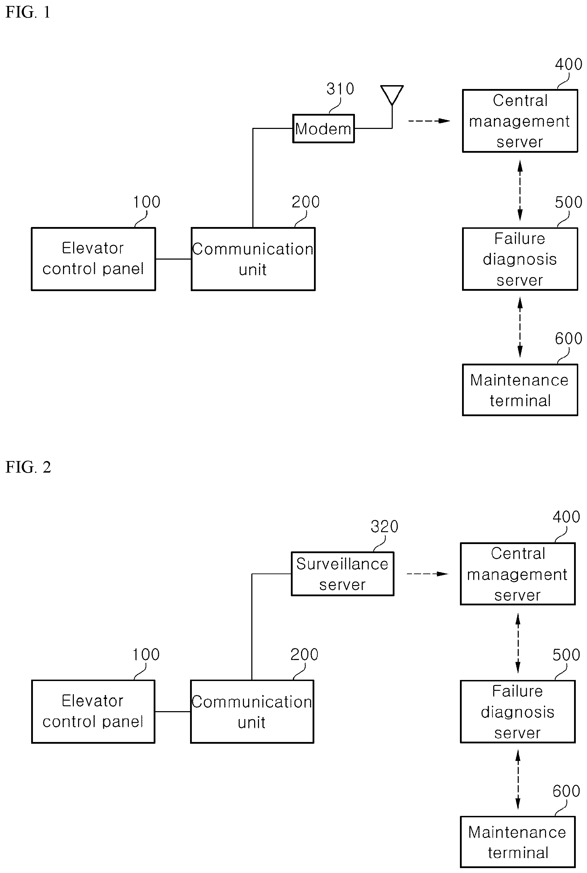

FIG. 1 is a conceptual block diagram of an overall configuration of an elevator maintenance management system according to one embodiment of the present invention and FIG. 2 is a conceptual block diagram of an overall configuration of an elevator maintenance management system according to another embodiment of the present invention.

An elevator maintenance management system according to one embodiment of the present invention includes a failure diagnosis server 500 configured to collect error code data from an elevator control panel 100 to diagnose a failure cause, and a maintenance terminal 600 configured to access the failure diagnosis server 500 to receive and display the error code data and a failure diagnosis result.

First, for the overall system configuration, the elevator may include a control panel 100 configured to control an operation state of the elevator. The control panel 100 may receive signals about operation state data of the elevator. The control panel may receive various failure occurrence signals. The operation state data and failure occurrence signals of the elevator may be generated by a plurality of sensors in the elevator. The control panel 100 may be configured to receive the operation state data and the failure occurrence signals of the elevator through the sensors. The control panel 100 may be configured to receive and store the operation state data and the failure occurrence signals of the elevator. In response to a failure occurrence signal, the control panel 100 may generate an error code that matches the failure occurrence signal.

The operation state signals and the error code data may be sent in real time to a central management server 400 through a communication unit 200. As shown in FIG. 1, the communication unit 200 may be configured to communicate with the central management server 400 through a modem 310 thereof to send the operation state signals and the error code data. When a separate surveillance system is present, as shown in FIG. 2, the communication unit 200 may communicate with the central management server 400 through a surveillance server 320 and send corresponding data.

The central management server 400 may be configured to send the received data to a separate failure diagnosis server 500. The failure diagnosis server 500 may be configured to receive the operation state signals and the error code data. The failure diagnosis server 500 may be implemented as a cloud server and may be connected to the maintenance terminal 600 via an internet protocol network. The operation state data of the elevator and the error code data received by the failure diagnosis server 500 may be sent to the maintenance terminal 600. In the maintenance terminal 600, a user may access the failure diagnosis server 500 through an application program to receive the operation state data of the elevator and the error code data. In addition, the failure diagnosis server 500 may be configured to analyze the received error code data to analyze a failure cause. The failure diagnosis server 500 may be configured to derive a diagnosis result of the failure cause. The derived diagnosis result may be provided to the maintenance terminal 600 through the application program of the maintenance terminal 600.

When a failure signal is generated from the elevator or a failure report is received, a maintenance worker may be selected according to the maintenance management system. Basic data about the elevator may be provided to the selected maintenance worker. The basic data about the elevator provided to the maintenance worker may include circumstances of the failure report or basic specifications of the elevator.

In the elevator maintenance management system according to the embodiment, error codes and a failure diagnosis result may be sent to the maintenance terminal through the failure diagnosis server 500. The maintenance worker can prepare necessary components or equipment before dispatching. As a result, a failure treatment time can be reduced and failure treatment work can be more easily performed.

In the following, details of the elevator maintenance management system according to the embodiment of the present invention will be described in more detail.

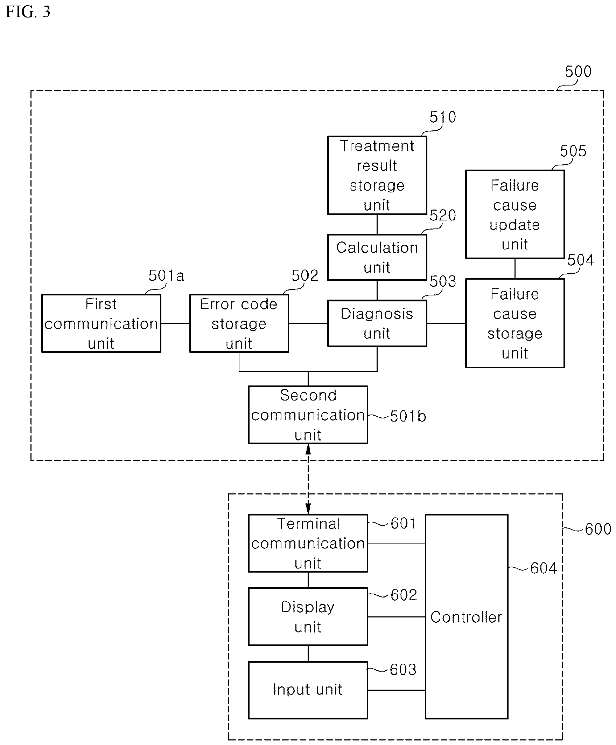

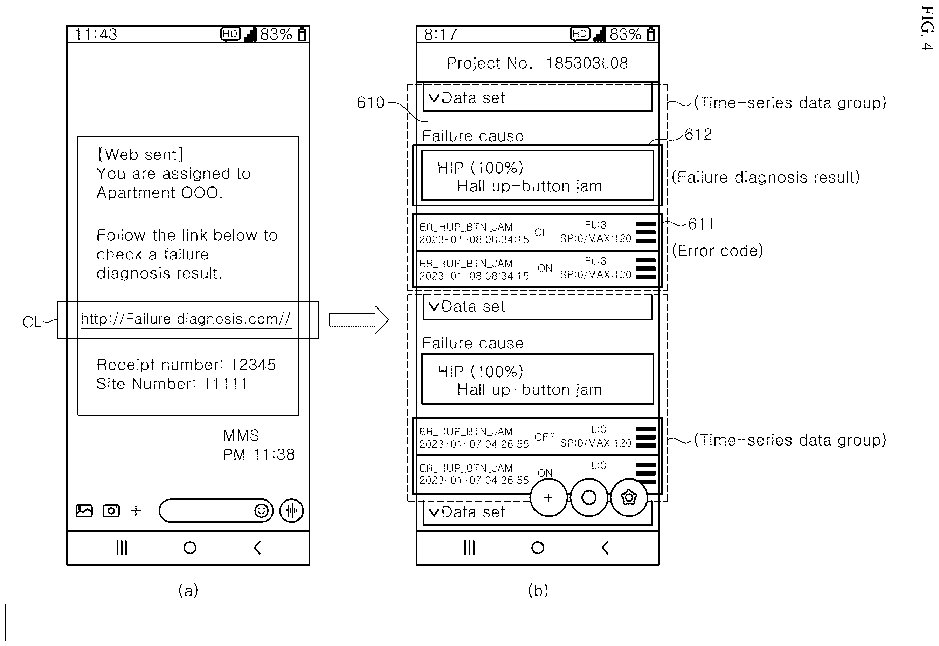

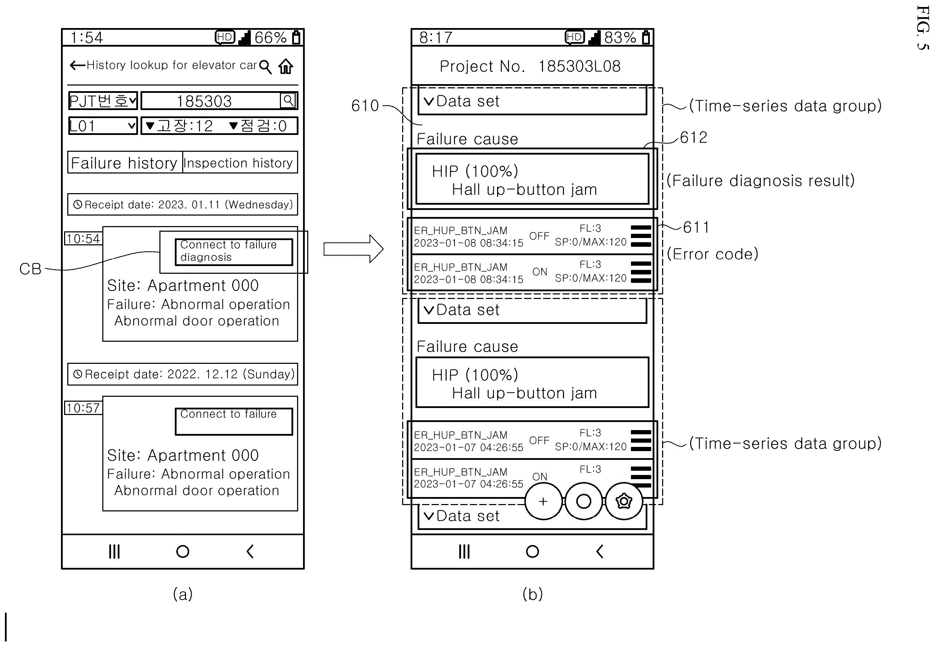

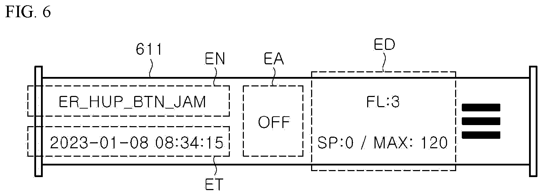

FIG. 3 is a block diagram of the failure diagnosis server and the maintenance terminal of the elevator maintenance management system according to the embodiment of the present invention, FIG. 4 and FIG. 5 are exemplary views illustrating a method of accessing the failure diagnosis server by the maintenance terminal and a method of displaying a failure diagnosis result in the elevator maintenance management system according to the embodiment of the present invention, and FIG. 6 is an exemplary view illustrating the form of error code data displayed on the maintenance terminal according to the embodiment of the present invention.

The elevator maintenance management system according to the embodiment of the present invention may include the failure diagnosis server 500 and the maintenance terminal 600, as described above.

The failure diagnosis server 500 may be configured to collect and store error code data of the elevator from the elevator control panel 100 and may be configured to diagnose a failure cause based on the collected error code data. The maintenance terminal 600 may be configured to access the failure diagnosis server 500 to receive and display the error code data and a diagnosis result for the failure sent from the failure diagnosis server 500.

The failure diagnosis server 500 may include a first communication unit 501a, an error code storage unit 502, a diagnosis unit 503, and a second communication unit 501b. In addition, the failure diagnosis server 500 may further include a treatment result storage unit 510 and a calculation unit 520, which will be described below.

The first communication unit 501a is configured to receive the error code data recorded in the elevator control panel 100 in real time. As described above, the error code data recorded in the elevator control panel 100 is sent to the central management server 400 and the first communication unit 501a may be configured to receive the error code data from the central management server 400 through communication with the central management server 400. In addition, the first communication unit 501a may be configured to receive the operation state data of the elevator in addition to the error code data recorded in the elevator control panel 100. For example, the first communication unit 501a may be configured to receive general operation state data of the elevator, such as a speed of the elevator, a floor number, a door operation state, and detection signals of various sensors. In particular, the first communication unit 501a may be configured to receive various data, such as data about change in operation state of the elevator upon generation of an error code.

The error code storage unit 502 may be configured to store the error code data, the operation state data of the elevator and the like received through the first communication unit 501a. The diagnosis unit 503 may be configured to analyze the error code data stored in the error code storage unit 502 to diagnose a failure cause. The diagnosis unit 503 may be configured to diagnose the failure cause in response to a data request signal received from the maintenance terminal 600.

The second communication unit 501b may be configured to receive the data request signal from the maintenance terminal 600 through communication with the maintenance terminal 600. The second communication unit 501b may be configured to send the error code data stored in the error code storage unit 502 and a failure diagnosis result derived by the diagnosis unit 503 to the maintenance terminal 600. The second communication unit 501b may also be configured to send various other data, such as the operation state data of the elevator stored in the error code storage unit 502, to the maintenance terminal 600.

The failure diagnosis server 500 may be configured to collect the error codes recorded in the elevator control panel 100 and the operation state data of the elevator through the first communication unit 501a and to store the error codes and the operation state data of the elevator in the error code storage unit 502. When the failure diagnosis server 500 receives a data request signal from the maintenance terminal 600, the failure diagnosis server 500 may diagnose a failure cause for the corresponding error code through the diagnosis unit 503. Further, the failure diagnosis server 500 may be configured to send the error code data, the failure diagnosis result, and the operation state data of the elevator to the maintenance terminal 600.

The maintenance terminal 600 may refer to a wirelessly communicable terminal carried by maintenance workers. The maintenance terminal 600 may include an input unit 603, a display unit 602, a terminal communication unit 601, and a controller 604.

The input unit 603 may be formed on the maintenance terminal 600 for input operation by maintenance workers. The input unit 603 may be formed on the maintenance terminal 600 by touch operation through a touch panel or may be formed in various forms, such as separate physical buttons and the like.

The display unit 602 may be configured to display the error code data sent from the failure diagnosis server 500, a failure diagnosis result, and the operation state data of the elevator, and the like. The display unit 602 may be formed as a display screen formed on the maintenance terminal 600.

The terminal communication unit 601 may be configured to send data request signals and the like to the failure diagnosis server 500 or to receive the error code data, the failure diagnosis result, the operation state data of the elevator, and the like from the failure diagnosis server 500 through communication with the second communication unit 501b of the failure diagnosis server 500.

The controller 604 may be configured to control the input unit 603, the display unit 602, and the terminal communication unit 601 of the maintenance terminal 600. When a maintenance worker generates an input signal through the input unit 603, the controller 604 may send a data request signal corresponding to the input signal to the failure diagnosis server 500 through the terminal communication unit 601. In response to the data request signal, the failure diagnosis server 500 may send the error code data, the failure diagnosis result, and the operation state data of the elevator to the controller 604 through the terminal communication unit 601. The controller 604 may control the display unit to display the error code data, the failure diagnosis result, and the operation state data of the elevator received from the failure diagnosis server 500 on the display unit 602.

In response to a failure signal from the elevator, a maintenance worker may be selected and basic data about the elevator may be provided to the selected maintenance worker through the maintenance terminal 600. In one embodiment, error code data and a failure diagnosis result may be further sent to the maintenance terminal 600 through the failure diagnosis server 500.

Here, in one embodiment, a confirmation request notification message may be sent to the maintenance terminal 600 of the maintenance worker to request to check the failure diagnosis result, as shown in FIG. 4. The confirmation request notification message may include a web link address CL of the failure diagnosis server where the failure diagnosis result can be confirmed. The confirmation request notification message may be sent via SMS to a mobile phone of the maintenance worker or to the maintenance terminal, as shown in FIG. 4.

An access input signal to the web link address CL may be generated by the maintenance worker touching the web link address CL included in an SMS type confirmation request notification message. In response to the access input signal, the controller 604 may be configured to send a data request signal corresponding to the web link address CL to the failure diagnosis server 500. The controller 604 may control the display unit 602 to display the error code data and the failure diagnosis result received from the failure diagnosis server 500 corresponding to transmission of the data request signal.

In other words, by touching the web link address CL of the confirmation request notification message sent to the maintenance terminal 600, the maintenance worker can access the failure diagnosis server 500 to check the error code and the failure diagnosis result.

On the other hand, as shown in FIG. 5, the maintenance worker may access the failure diagnosis server through a separate maintenance management program installed in the maintenance terminal. For example, a connection button CB may be formed in the maintenance management program of the maintenance terminal. By touching the connection button CB, the maintenance worker may generate an access input signal with respect to the failure diagnosis server 500. The controller 604 may send a data request signal corresponding to the connection button CB to the failure diagnosis server 500 in response to the access input signal and control the display unit 602 to display the error code data and the failure diagnosis result received from the failure diagnosis server 500 corresponding to transmission of the data request signal.

In other words, the elevator maintenance management system may be configured to allow the maintenance worker to access the failure diagnosis server 500 to check the error codes, the failure diagnosis results, and the like by touching the connection button CB formed in the maintenance management program of the maintenance terminal 600. In this case, a connection button CB may be formed in the form of a button labeled with a phrase, such as "Connect to failure diagnosis," as shown in FIG. 5.

In the maintenance management program, when the maintenance worker wants to check failure data, such as past failure data of the elevator for reference while checking past failure treatment results, the maintenance worker can check the past failure data and the failure diagnosis results through the connection button CB. In other words, in the maintenance management program, the maintenance worker can check the failure data and the failure diagnosis results of the elevator at any time by touching the connection button CB. As a result, it is possible to improve accuracy of maintenance work and such data and diagnosis results can be utilized as reference data for maintenance work even by non-experts.

To summarize, upon occurrence of a failure in an elevator, basic data about the elevator may be sent together with confirmation request notification for an error code and a failure diagnosis result of the elevator to the maintenance terminal of the selected maintenance worker. This can be carried out in the form of a text message. When an access input signal is generated through the link address CL included in the text message or the connection button CB of the maintenance management program, a data request signal may be sent to the failure diagnosis server 500, and the maintenance terminal 600 may receive the error code and the failure diagnosis result from the failure diagnosis server 500 and may display the error code and the failure diagnosis result on the display unit 602.

Accordingly, since the maintenance worker can check the error code and the failure diagnosis result of the corresponding elevator before dispatching to a failure site, the maintenance worker can prepare necessary components and equipment in advance.

On the other hand, the error code storage unit 502 of the failure diagnosis server 500 may be configured to arrange and store the error code data received through the first communication unit 501a in a time sequence. The error code storage unit 502 may be configured to store the error code data by classifying the error code data into one time-series data group at every preset reference time interval. The diagnosis unit 503 may be configured to analyze the corresponding error code data for each time-series data group stored in the error code storage unit 502 to diagnose a failure cause for the time-series data group.

In addition, the display unit 602 of the maintenance terminal 600 may include a first output screen 610 having an error code display region 611 in which error code data is displayed, and a diagnosis result display region 612 in which failure diagnosis results are displayed, as shown in FIG. 4 and FIG. 5. In the error code display region 611, at least one error code may be displayed in a time sequence for each time-series data group classified in the failure diagnosis server 500. In other words, one time-series data group is displayed in one error code display region 611. Here, one diagnosis result display region 612 may be formed corresponding to one error code display region 611 such that a failure diagnosis result can be displayed for each time-series data group.

Further, as shown in FIG. 6, the error code data displayed in the error code display region 611 includes an error code name (EN), an error code occurrence time (ET), and elevator operation state data (ED) upon occurrence of the error code. In addition, activation information (EA) for the corresponding error code may also be displayed.

For example, the error code name (EN) may be displayed as "ER_HUP_BTN_JAM" to indicate the type of error code and the error code occurrence time (ET) may be displayed in a region under the error code name. Further, the elevator operation state data ED generated upon occurrence of the error code may include the number of floors, the current speed/maximum speed (in FIG. 6, 3 floors, current speed 0/maximum speed 120), and the like. Further, the activation information (EA) of the error code indicates whether the error code is currently activated or deactivated, and when the activation information is displayed as "OFF" as shown in FIG. 6, it can be understood that the error code is currently deactivated.

According to this structure, when a maintenance worker accesses the failure diagnosis server 500 through the maintenance terminal 600, the maintenance terminal 600 displays error code data and failure diagnosis data for the corresponding elevator on the screen. Here, since the error code data includes the error code name, the time of occurrence, and the elevator operation state data, the maintenance worker can check the basic operation state data of the elevator in addition to the failure diagnosis result provided from the failure diagnosis server 500, and can also infer a failure diagnosis result through the related error code data.

That is, in the embodiment of the invention, by accessing the failure diagnosis server 500 through the maintenance terminal 600, the maintenance worker can check all error codes generated in the corresponding elevator, and thus can predict and determine an on-site situation before dispatching to the failure site.

As such, by receiving the error code and the operation state data of the elevator in addition to the failure diagnosis result through the maintenance terminal 600, a skilled maintenance worker can determine a failure cause that is different from the failure diagnosis result provided by the failure diagnosis server 500, thereby achieving more accurate anticipation and on-site response. In addition, an unskilled maintenance worker can use the failure diagnosis result provided by the failure diagnosis server 500 as a reference to facilitate on-site response.

In addition, a large number of error codes is generated in a period of time before and after the occurrence of a failure and the failure diagnosis server 500 may receive error code data detected by the control panel 100 of the elevator in real time. The failure diagnosis server 500 can collect all error code data and elevator operation state data generated during the period of time before and after the occurrence of the failure, thereby providing more accurate failure diagnosis results.

Furthermore, the failure diagnosis server 500 can diagnose a failure cause for each time-series group by separately categorizing error codes, which are sequentially generated in a very short period of time, into a time-series group in a reference time, thereby providing more rapid and accurate diagnosis results. The reference time may be set by the error code storage unit 502 of the failure diagnosis server 500.

For example, the error code storage unit 502 of the failure diagnosis server 500 may be configured to set a reference time of 5 minutes and may store a plurality of error codes classified into one time-series data group at every 5 minute interval. When a failure occurs in the elevator, error code data are generated continuously before and after the occurrence of the failure and may be classified into one time-series data group at every 5 minute interval. As such, the failure cause is diagnosed and provided for each time-series data group. Accordingly, the error code data generated at very short time intervals of a few seconds can be rapidly classified and analyzed upon occurrence of the failure, thereby enabling rapid deduction of diagnosis results while improving the processing speed and accuracy of maintenance work.

On the other hand, a failure diagnosis program capable of diagnosing failure causes by analyzing the error code data may be installed in the failure diagnosis server 500. The failure diagnosis program may be adapted to diagnose the failure causes based on data input in advance by a skilled technician.

To this end, the failure diagnosis server 500 may include a failure cause storage unit 504 configured to match and store a plurality of predetermined reference error code data and at least one failure cause corresponding to the reference error code data.

The diagnosis unit 503 may be configured to diagnose failure causes for the error code data based on data stored in the failure cause storage unit 504. For example, the diagnosis unit 503 may be configured to diagnose the failure causes for the error code data in a machine learning manner by training the mutually matched error code data and at least one failure cause as training data.

In addition, when maintenance work is completed at a work site, the maintenance worker may input a failure treatment result. Here, the input failure treatment result may be sent to the failure diagnosis server 500 through the central management server 400. The failure diagnosis server 500 may change the data stored in the failure cause storage unit 504 to reflect such information about the failure treatment result of the maintenance worker.

To this end, the failure diagnosis server 500 may include a failure cause update unit 505 configured to reflect the information about the failure treatment result input by the maintenance worker to update the failure cause matching to the reference error code data stored in the failure cause storage unit 504.

By the failure cause update unit 505, the information about the error code and the failure cause stored in the failure cause storage unit 504 are updated and accuracy of the information about the error code and the failure cause can be improved as the amount of data of the failure treatment results increases. Thus, the elevator maintenance management system according to the embodiment of the invention can improve accuracy and reliability of the failure diagnosis results of the failure diagnosis server 500 over time.

On the other hand, when an error occurs in communication between the elevator control panel 100, the central management server 400, and the failure diagnosis server 500 for a certain period of time, the error code data stored in the elevator control panel 100 may not be sent to the failure diagnosis server 500 for a period of time for which the error continues. In this case, since all of the error code data are not sent to the failure diagnosis server 500, accuracy of the failure diagnosis results of the failure diagnosis server 500 diagnosing the failure causes based on the error code data can be deteriorated. To prepare for this case, a manual collection button may be formed on the first output screen 610 of the maintenance terminal 600. When the maintenance worker touches the manual collection button, the error code data and the like may be collected from the elevator control panel 100 to the failure diagnosis server 500 once again for a certain period of time.

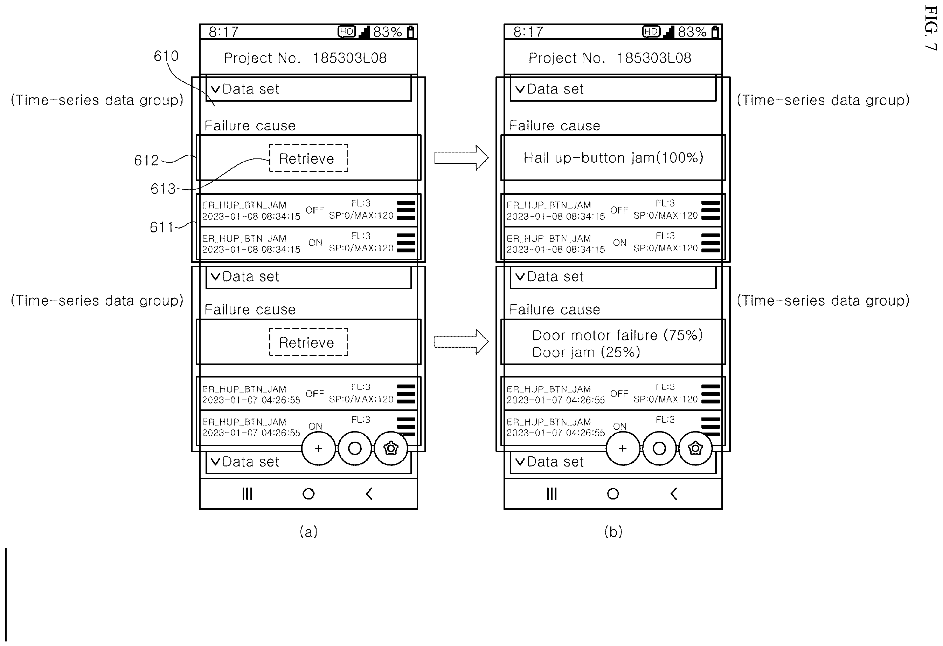

FIG. 7 is an exemplary view illustrating a method of displaying failure diagnosis results in the maintenance terminal according to the embodiment of the present invention.

In the elevator maintenance management system according to the embodiment, when a data request signal is sent to the failure diagnosis server 500 in response to an access input signal from the maintenance terminal 600 as described above, an error code and a failure diagnosis result for each time-series data group may be sent from the failure diagnosis server 500 to the maintenance terminal 600 and may be displayed thereon.

However, when the access input signal is sent from the maintenance terminal 600, a data request signal for the error code may be sent to the failure diagnosis server 500 and a plurality of error code data for each time-series data group may be sent from the failure diagnosis server 500 to the maintenance terminal 600 and displayed thereon, as shown in FIG. 7. When a data request signal requesting a failure diagnosis result is sent through the maintenance terminal 600, the diagnosis unit 503 of the failure diagnosis server 500 may diagnose a failure cause for the error code for each time-series data group. The failure diagnosis server 500 may be configured to send the corresponding failure diagnosis results to the maintenance terminal 600 to be displayed thereon.

That is, the failure diagnosis server 500 may be configured to diagnose the failure causes through the failure diagnosis program and provide the failure diagnosis results to the maintenance terminal when the maintenance worker requests such diagnosis results, instead of immediately providing the failure diagnosis results for the error codes in one time-series data group upon accessing the failure diagnosis server 500.

More specifically, when an access input signal is generated by a maintenance worker touching the link address CL sent as a text message to the maintenance terminal 600 or touching the connection button CB of the maintenance management program, the controller 604 of the maintenance terminal 600 may send a data request signal for error code data to the failure diagnosis server 500. When the failure diagnosis server 500 receives the data request signal, error codes for each time-series data group stored in the error code storage unit 502 are sent to the maintenance terminal 600 and the controller 604 of the maintenance terminal 600 may control the display unit 602 to display the error codes for each time-series data group.

Here, as shown in (a) of FIG. 7, the controller 604 of the maintenance terminal 600 may be configured to control the display unit 602 to form a diagnosis result request input button 613 in the diagnosis result display region 612 so as to allow input of data request signals for failure diagnosis results, with the error code data displayed in a classified state for each time-series data group in the error code display region 611. As described above, since the diagnosis result display region 612 is formed one by one in the error code display region 611 separated for each time-series data group and the diagnosis result request input button 613 is formed in the diagnosis result display region 612, one diagnosis result request input button 613 can be formed for each time-series data group.

In the displayed state, when the maintenance worker touches the diagnosis result request input button 613 of any one of the time-series data groups, an input signal requesting a failure diagnosis result may be generated. When such an input signal is generated, the controller 604 of the maintenance terminal 600 may send a data request signal to the failure diagnosis server 500 to request a failure diagnosis result for the error code data of the corresponding time-series data group corresponding to the diagnosis result request input button 613. In response to such a data request signal, the failure diagnosis server 500 diagnoses a failure cause for the error code of the corresponding time-series data group through the diagnosis unit 503 to derive a diagnosis result. The derived failure diagnosis result may be sent from the failure diagnosis server 500 to the maintenance terminal 600. The controller 604 of the maintenance terminal 600 may be configured to control the display unit 602 to display the received failure diagnosis result of the time-series data group in the diagnosis result display region 612 of the corresponding time-series data group on the first output screen 610. At the same time, the controller 604 may control the display unit to remove the diagnosis result request input button 613 displayed in the diagnosis result display region 612. In other words, when the failure diagnosis result is sent to the maintenance terminal 600, the diagnosis result display region 612 may display the failure diagnosis result as soon as the diagnosis result request input button 613 is removed, as shown in (b) of FIG. 7.

The diagnosis result request input button 613 formed in the diagnosis result display region 612 may be generated in the form of a "retrieve" text to be touched by a maintenance worker, as shown in FIG. 7.

With this structure, the failure diagnosis server 500 can diagnose failure causes for a particular time-series data group only when a failure diagnosis result request signal is sent from the maintenance terminal 600. Accordingly, there is no need to repeatedly diagnose failure causes for all past error codes and there is no need to separately store the failure diagnosis results for all past error codes, thereby preventing overloading of the failure diagnosis server 500 while minimizing the capacity thereof.

On the other hand, the diagnosis unit 503 of the failure diagnosis server 500 may derive at least one failure cause and occurrence probability information for each failure cause together as a diagnosis result in the course of diagnosing the failure causes for error code data of one time-series data group. The derived failure causes and occurrence probability information may be displayed together in the diagnosis result display region 612 of the maintenance terminal 600.

For example, as shown in (b) of FIG. 7, a failure diagnosis result for the first time-series data group may be displayed as "Hall up-button jam (100%)". This may mean that a failure cause is a hall up-button jam and the corresponding failure probability is 100%. The failure diagnosis for the second time-series data group may be displayed as "Door Motor Failure (75%), Door Stuck (25%)". This may mean that there is 75% probability that the failure cause is door motor failure and there is 25% probability that the failure cause is a door jam.

By displaying the probability information about the failure cause together with other data, the maintenance worker can take the probability information into account upon determining an operation sequence during the failure treatment process, enabling faster and more accurate maintenance work.

On the other hand, when the failure cause and/or the occurrence probability information displayed in the result display region 612 are/is selected, a maintenance guide corresponding to the failure cause may be displayed. The maintenance guide may include components and/or methods for repairing a displayed failure.

In the above, the process of diagnosing a failure cause for an error code through the failure diagnosis server 500 and displaying the diagnosis result on the maintenance terminal 600 in the event of failure of an elevator, that is, a failure treatment transfer process, is described. Such a failure treatment transfer process enables the failure treatment operation as described above to be performed more quickly and efficiently. Then, the maintenance worker inputs the failure treatment result to the maintenance terminal 600 upon completion of the failure treatment operation.

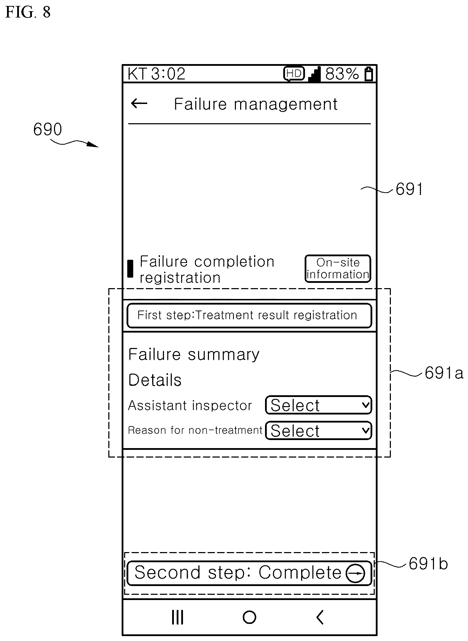

Next, the configuration of the maintenance terminal 600 that can accurately input such a failure treatment result without input errors or omissions will be described with reference to FIG. 8 to FIG. 11.

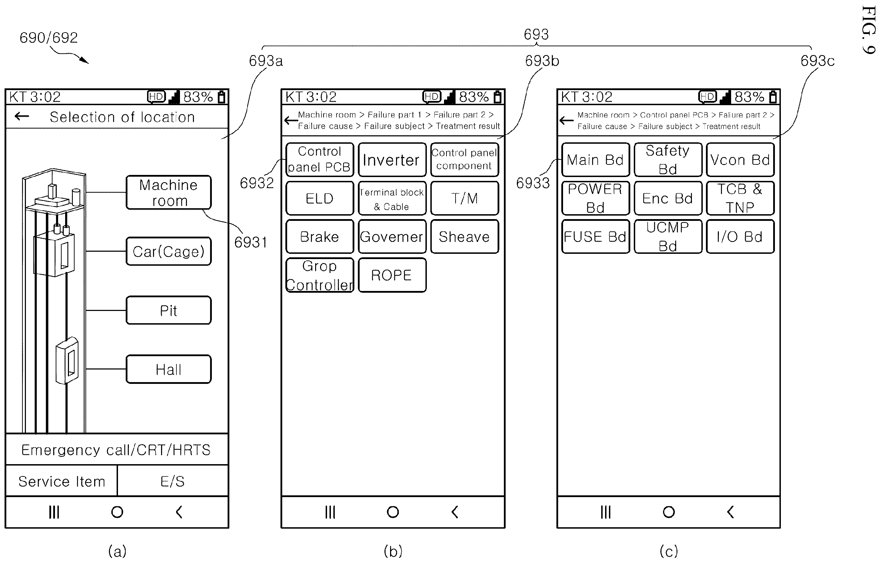

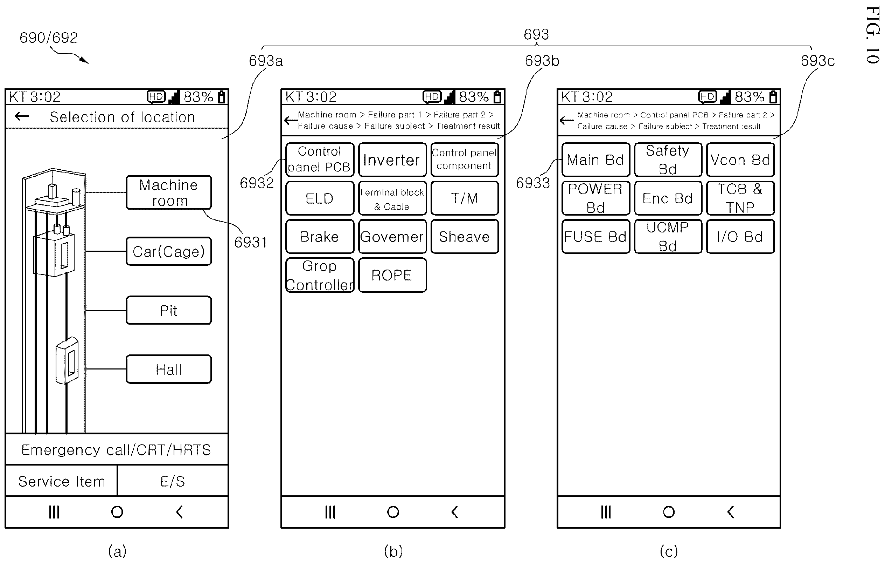

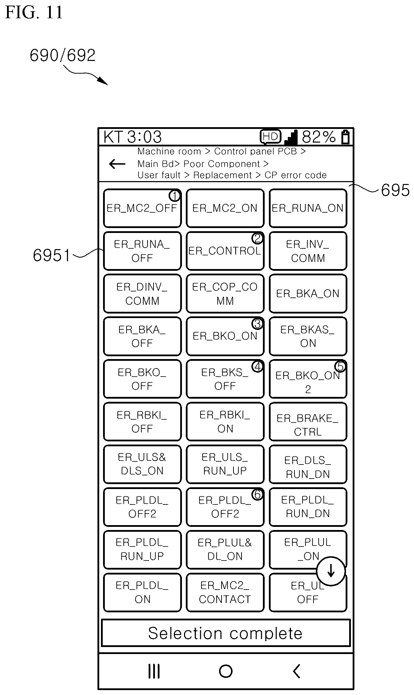

FIG. 8 is an exemplary view of a basic data input screen on a treatment result input screen of the maintenance terminal according to the embodiment of the present invention, FIG. 9 shows exemplary views of a component selection input screen of a selection input screen of a treatment result input screen according to one embodiment of the present invention, FIG. 10 shows exemplary views of an additional selection input screen of the selection input screen of the treatment result input screen according to the embodiment of the present invention, and FIG. 11 is an exemplary view of an error code selection input screen of the selection input screen of the treatment result input screen according to the embodiment of the present invention.

Referring to FIG. 8, the maintenance terminal 600 according to the embodiment of the present invention may include a treatment result input screen 690 on which a maintenance worker inputs a failure treatment result after completion of failure treatment operation.

The treatment result input screen 690 may include a basic data input screen 691 configured to allow input of basic data for failure treatment operation, and a plurality of selection input screens 692 configured to allow a failure treatment result to be input by selecting the failure treatment result through a plurality of selection buttons.

On the basic data input screen 691, a basic data input region 691a may be formed to allow input of basic data for failure treatment operation, as shown in FIG. 8. The basic data input region 691a may be configured to allow input of various data related to the failure treatment operation. For example, in the basic data input region 691a, a maintenance worker can input a fault summary, details, and the like. A secondary inspector may be selected through a secondary inspector selection menu. In the event that failure treatment is not completed, a reason for non-treatment may be selected through a "Reason for Non-treatment" menu formed in the basic data input region 691a.

The basic data input screen 691 may include a completion button 691b formed for screen conversion to a selection input screen 692 described below. When the maintenance worker touches the completion button 691b after inputting the basic data through the basic data input region 691a, a display screen of the maintenance terminal may display the selection input screen 692.

Referring to FIG. 9 to FIG. 11, data about a faulty part of the elevator may be input on the selection input screen 692. The selection input screen 692 may be formed in plural to be sequentially displayed according to manipulation of the maintenance worker. Each of the selection input screens 692 may be formed with a plurality of selection buttons configured to display faulty components, additional data about failure, error codes, and the like. These selection input screens 692 may include a component selection input screen 693, an additional selection input screen 694, and an error code selection input screen 695.

The component selection input screen 693, the additional selection input screen 694, and the error code selection input screen 695 may be sequentially displayed according to input manipulation of the maintenance worker. That is, when selection operation for a selection button on the component selection input screen 693 is completed, the additional selection input screen 694 is displayed, and when selection operation for a selection button of the additional selection input screen 694 is completed, the error code selection input screen 695 is finally displayed. The maintenance worker may complete input operation of a failure treatment result by selecting a selection button on the error code selection input screen 695.

In this way, each of the plurality of selection input screens 692: 693, 694, 695 may include a separate screen conversion tab for screen conversion in an upper region thereof and screen conversion for the plurality of selection input screens may be performed by the maintenance worker in a manner of touching the screen conversion tab. Alternatively, a separate selection completion button (not shown) may be displayed on each of the selection input screens and a screen conversion method may be set in various ways, for example, by conversion to the next selection input screen upon touch operation with respect to the selection completion button.

Since the failure treatment result can be input by selecting a specific selection button among the plurality of selection buttons on each of the plurality of selection input screens 692: 693, 694, 695 that are sequentially displayed, a manual input process is eliminated in the process of inputting the failure treatment result, whereby the failure treatment result can be accurately input without input errors or omissions of the failure treatment result. Even unskilled maintenance workers can easily input the failure treatment result without difficulty.

Next, the selection input screen 692 will be described in more detail.

First, the component selection input screen 693 may be configured to allow the maintenance worker to select and input a faulty component. In other words, the component selection input screen 693 may be configured to allow data about the faulty component to be selected and input. The component selection input screen 693 may include a plurality of failure selection buttons 6931, 6932, 6933 each configured to display a possible faulty region, a possible faulty part, and a possible faulty component in the elevator to be selected by the maintenance worker.

Such a component selection input screen 693 may include a first stage selection input screen 693a, a second stage selection input screen 693b, and a third stage selection input screen 693c, as shown in FIG. 9.

On the first stage selection input screen 693a, a plurality of large classification selection buttons 6931 each configured to display a primary classification of possible faulty regions in the elevator may be formed to be selected by the maintenance worker. As shown in FIG. 9 (a), the large classification selection buttons 6931 may be formed to display visual images of the elevator together with the corresponding locations. The large classification selection buttons 6931 may include four large classification selection buttons 6931 configured to classify the possible faulty regions of the elevator into four broad regions. For example, the large classification buttons 6931 may be formed to classify the possible faulty regions of the elevator into at least four groups: machine room, elevator car (cage), hoistway/foot, and hall. By touching any one of these classification selection buttons 6931, the maintenance worker can make a primary selection of a faulty region in the large classification step. It should be understood that this structure is provided by way of example and the large classification selection buttons 6931 may be formed to have a different number of possible faulty regions in the elevator, such as three or five faulty regions.

On the second stage selection input screen 693b, a plurality of faulty part selection buttons 6932 each configured to display possible faulty parts in a faulty region corresponding to a large classification selection button 6931 selected through the first stage selection input screen 693a may be formed to be selected by the maintenance worker. For example, as shown in FIG. 9(b), when a large classification selection button 6931 for the machine room is selected on the first stage selection input screen 693a, the second stage selection input screen 693b may be formed with faulty part selection buttons 6932 configured to display possible faulty parts in the machine room, for example, a control panel PCB, an inverter, a control panel component, and the like.

On the third stage selection input screen 693c, a plurality of faulty component selection buttons 6933 configured to display possible faulty components in a faulty part corresponding to the faulty part selection button 6932 selected through the second-stage selection input screen 693b may be formed to be selected by the maintenance worker. For example, as shown in FIG. 9(c), when a faulty part selection button 6932 for the control panel PCB is selected on the second stage selection input screen 693b, the third stage selection input screen 693c may be formed with a plurality of faulty component selection buttons 6933 configured to display possible faulty components in the control panel PCB, such as a main board, a safety board, a power board, and the like.

Each of the first stage selection input screen 693a, the second stage selection input screen 693b, and the third stage selection input screen 693c may sequentially display the next stage selection input screen, when selection manipulation of the maintenance worker is completed on each of the selection input screens.

For example, as described above, when the large classification selection button 6931 for the machine room is selected on the first selection input screen 693a, the display screen of the maintenance terminal displays the second selection input screen 693b, and when the faulty component selection button 6932 for the control panel PCB is selected on the second selection input screen 693b, the display screen of the maintenance terminal displays the third stage selection input screen 693c. When at least one faulty component selection button on the three selection input screens 693c, for example, a faulty component selection button 6933 for the main board, is selected on the third stage selection input screen 693c, an additional selection input screen 694 described below is displayed. Here, each selection input screen may have the screen conversion tab or the separate selection completion button formed as described above to allow screen conversion.

When a selection input process for the component selection input screen 693 including these three selection input screens 693a, 693b, 693c is completed, the additional selection input screen 694 may be displayed on the display screen of the maintenance terminal.

The additional selection input screen 694 may be formed for selection and input of additional data about failure, as shown in FIG. 10. On the additional selection input screen 694, a plurality of additional selection buttons 6941, 6942, 6943 configured to display a failure cause, a failure subject, and a type of failure treatment operation, respectively, may be formed to be selected by the maintenance worker.

These additional selection input screens 694 may include a failure cause selection input screen 694a, a failure subject selection input screen 694b, and a treatment operation selection input screen 694c.

On the failure cause selection input screen 694a, a plurality of additional failure cause selection buttons 6941 each configured to display a possible failure cause in the elevator may be formed to be selected by the maintenance worker. For example, as shown in FIG. 10(a), a plurality of additional failure cause selection buttons 6941 each configured to display a type of failure cause, such as a poor component, poor installation, poor contact, and the like, may be formed.

On the failure subject selection input screen 694b, a plurality of additional failure subject selection buttons 6942 each configured to display a failure subject for possible failure in the elevator may be formed to be selected by the maintenance worker. For example, as shown in FIG. 10(b), a plurality of additional failure subject selection buttons 6942 each configured to display a type of failure subject, such as an inspection item, user error, power failure, and the like may be formed.

On the treatment operation selection input screen 694c, a plurality of additional treatment operation selection buttons 6943 each configured to display a type of treatment operation for possible failure in the elevator is formed to be selected by the maintenance worker. For example, as shown in FIG. 10(c), a plurality of additional treatment operation selection buttons 6943 each configured to display a type of failure treatment operation, such as adjustment, replacement, removal, and the like may be formed.

Each of the failure cause selection input screen 694a, the failure subject selection input screen 694b, and the treatment operation selection input screen 694c may sequentially display the next selection input screen when selection manipulation of the maintenance worker is completed on each of the selection input screens.

For example, as described above, when the additional failure cause selection button 6941 for a component failure is selected on the failure cause selection input screen 694a, the display screen of the maintenance terminal may display the failure subject selection input screen 694b. When an additional failure cause selection button 6942 for an inspection item is selected on the failure cause selection input screen 694b, the display screen of the maintenance terminal may display the treatment operation selection input screen 694c. When an additional treatment operation selection button 6943 for adjustment is selected on the treatment operation selection input screen 694c, the error code selection input screen 695 described below is displayed. Here, the screen conversion tab or the separate selection completion button may be formed on each of the selection input screens as described above to allow screen conversion. In addition, a single selection button or a plurality of selection buttons may be set to be selected on each of the additional selection input screen 694.

When the selection input process for the additional selection input screen 694 including the three selection input screens 694a, 694b, 694c is completed, the display screen of the maintenance terminal may display the error code selection input screen 695. The error code selection input screen 695 may be displayed after the selection input process for the additional selection input screen 694. However, since the additional selection input screen 694 is provided to input additional data about failure, the additional selection input screen 694 may be omitted, as needed, and the error code selection input screen 695 may be displayed after the selection input process for the component selection input screen 693.

On the error code selection input screen 695, a plurality of error code selection buttons 6951, each configured to display a possible error code for a faulty component selected through the component selection input screen 693, as shown in FIG. 11, may be formed to be selected by the maintenance worker. For example, the maintenance worker may select a faulty component selection button 6933 for a final faulty component (motherboard) on the third stage selection input screen 693c through the steps of the first to third stage selection input screens 693a, 693b, 693c of the component selection input screen 693. Here, the plurality of error code selection buttons 6951 each configured to display all possible error codes for the selected faulty component may be formed on the error code selection input screen 695.

The maintenance worker may selectively input the error code selection button 6951 by touching an error code selection button 6951 corresponding to an error code for failure treatment of the maintenance worker among the plurality of error code selection buttons, thereby finally completing input operation of a failure treatment result.

Since a plurality of error codes occurs in the event of failure of the elevator, the maintenance worker may select a plurality of error code selection buttons 6951 on the error code selection input screen 695. FIG. 11 illustrates an example in which six error code selection buttons 6951 are selected, and as shown in FIG. 11, the six selected error code selection buttons 6951 may be marked with different colors or shapes to be distinguished from unselected error code selection buttons 6951.

In addition, the error code selection input screen 695 may be configured to display selection orders of the error code selection buttons 6951 in a region at one side of the error code selection buttons 6951 while the maintenance worker touches the plurality of error code selection buttons 6951 to make a selection. By way of example, in FIG. 11, such selection orders may be displayed in the form of figures in red circles in upper right regions of the error code selection buttons 6951.

As such, when the maintenance worker inputs a failure treatment result by selecting the plurality of selection buttons instead of manual input through the maintenance terminal, the failure treatment result can be accurately input without input errors or omissions. In addition, even an unskilled maintenance worker can easily input the failure treatment result.

On the other hand, since the failure treatment result input to the maintenance terminal in this manner has high accuracy, the failure treatment result may be collected by the failure diagnosis server 500 described with reference to FIG. 1 to FIG. 7 and reflected in the failure cause diagnosis process of the failure diagnosis server 500.

In the elevator maintenance management system according to the embodiment of the present invention, the failure diagnosis server 500 may be configured to collect and store error code data of the elevator from the elevator control panel 100, as described above. The failure diagnosis server 500 may be configured to diagnose a failure cause based on the collected error code data. The error code data and failure diagnosis results may be sent to the maintenance terminal to be displayed thereon.

Here, the failure diagnosis server 500 may be configured to collect the failure treatment results input through the selection input screen 692 of the maintenance terminal 600. In the process of diagnosing the failure cause based on the error code data, the failure diagnosis server 500 may diagnose the failure cause by reflecting the previously collected failure treatment results.

More specifically, the failure diagnosis server 500 may include the failure cause storage unit 504 and the failure cause update unit 505, as described above, to improve failure diagnosis accuracy of the diagnosis unit 503. The failure cause update unit 505 may be configured to reflect information about the failure treatment result input by the maintenance worker to newly match the failure cause to the reference error code data stored in the failure cause storage unit 504.

Accordingly, higher accuracy of the failure treatment results input by the maintenance worker can provide better diagnosis accuracy of the diagnosis unit 503.

In the embodiment of the present invention, the failure treatment result is input in a selection input manner through the selection input screens 692 of the maintenance terminal 600, thereby securing improvement in input accuracy. Since such a highly accurate failure treatment result is reflected in the failure cause storage unit 504 through the failure cause update unit 505, failure diagnosis accuracy of the diagnosis unit 503 can be further improved. In particular, as the amount of data of accurate failure treatment results accumulates, accuracy of information on error codes and failure causes can continue to increase. Accordingly, the maintenance management system of the elevator according to the embodiment of the present invention can continue to improve accuracy and reliability of the failure diagnosis results of the failure diagnosis server 500 over time.

In the above, in the elevator maintenance system according to the embodiment of the present invention, the configuration of analyzing an error code to diagnose a current failure cause and displaying a diagnosis result upon occurrence of failure in the elevator, and the configuration of inputting a failure treatment result after completion of failure treatment have been described.

In addition to these functions, the elevator maintenance system according to the embodiment of the present invention has a configuration of predicting future failure. Hereinafter, the failure prediction configuration will be described.

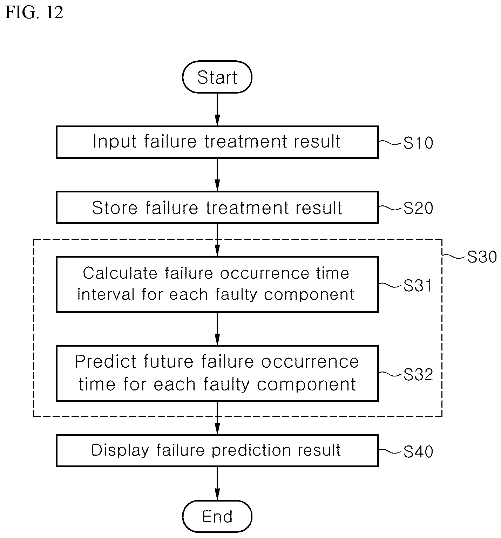

FIG. 12 is a flow diagram illustrating a method of predicting failure of an elevator maintenance system according to one embodiment of the present invention.

First, referring to FIG. 3, the failure diagnosis server 500 may include the first communication unit 501a, the error code storage unit 502, the diagnosis unit 503, and the second communication unit 501b, as described above. With such a structure, the failure diagnosis server 500 collects and stores error code data of an elevator from the elevator control panel 100, and diagnoses a failure cause based on the collected error code data.

The maintenance terminal 600 may be configured to access the failure diagnosis server 500 to receive and display the error code data and a diagnosis result for the failure cause sent from the failure diagnosis server 500. In addition, the maintenance terminal 600 is configured to input failure treatment results, such as faulty component and error code data, after completion of failure treatment.

Here, the failure diagnosis server 500 may be configured to collect and store the failure treatment results input from the maintenance terminal 600. In addition, the failure diagnosis server 500 may be configured to predict a possible future faulty component and a future failure occurrence time through application of the stored failure treatment results together with failure occurrence time data to a separate machine learning model. The maintenance terminal 600 may be configured to receive and display a failure prediction result sent from the failure diagnosis server 500.

As shown in FIG. 3, the failure diagnosis server 500 may include a treatment result storage unit 510 configured to collect and store the failure treatment results input from the maintenance terminal 600 together with the failure occurrence time data, and a calculation unit 520 configured to predict a possible future faulty component and a future failure occurrence time through application of the faulty component and error code data of the failure treatment results and failure occurrence time data of each faulty component to a separate machine learning model.

Here, the machine learning model used by the calculation unit 520 is different from the machine learning model used by the diagnosis unit 503 configured to diagnose the failure cause and a separate machine learning model may be applied to prediction of possible future failure using past failure treatment results as training data.

More specifically, the treatment result storage unit 510 may be configured to classify the failure treatment results collected from the maintenance terminal 600 for each faulty component and configured to sequentially store the failure treatment results in a time sequence of failure occurrence. The calculation unit 520 may be configured to calculate a failure occurrence time interval for each faulty component stored in the treatment result storage unit 510. Further, the calculation unit 520 may be configured to predict a future failure occurrence time for each faulty component through application of each faulty component, the error code data and the failure occurrence time interval for each faulty component to the machine learning model.

Failure history from past failure to current failure of an elevator may be present in the form of multiple faults occurring in multiple components. The treatment result storage unit 510 may collect all of failure history data for the elevator and to arrange and store the failure history data for each faulty component in a time sequence of failure occurrence. For example, the failure history data may be arranged according to a time sequence of failure occurrence for each individual faulty component, such as a main board, a door motor, and the like. Here, the treatment result storage unit 510 may store faulty components and error code data matched with the faulty components through the error code data input during a failure treatment result input process.

The calculation unit 520 may calculate the failure occurrence time interval for each faulty component. Thereafter, the calculation unit 520 may predict a future failure occurrence time for each faulty component by applying each faulty component, the error code data and the failure occurrence time interval for each faulty component to a machine learning model. For example, the calculation unit 520 may determine that failure occurrence time intervals for a main board are 1 month, 3 months, and 12 months from a construction date. In addition, the calculation unit 520 may predict that the main board will fail in the future at 24 months from the construction date. Further, the calculation unit 520 may determine that failure occurrence time intervals of a door motor are 0.5 months, 1 month, 3 months, and 18 months from the construction date, and may predict that the door motor will fail in the future at 40 months from a construction date.

In this way, a failure prediction result predicted by the calculation unit 520 may be sent to the maintenance terminal 600 to be displayed thereon. The maintenance terminal 600 may be formed with a separate failure prediction display screen (not shown), which may display a predicted failure occurrence time for each faulty component. Alternatively, the predicted failure occurrence time for each faulty component may be displayed on any of the treatment result input screens 690 described above or may be configured to be displayed through screen switching. Further, a faulty component predicted to fail first from a current point of time or a faulty component predicted to fail within a certain period of time may be set to be displayed with separate notifications.

As the failure prediction results are displayed on the maintenance terminal 600, a maintenance worker can repair a particular faulty component in advance with reference to the failure prediction results during maintenance work. In particular, if a possible failure is imminent, a maintenance worker may be dispatched to the corresponding elevator site separately from maintenance work to repair the corresponding faulty component in advance. As a result, failure of the elevator can be prevented in advance before failure occurrence of the elevator, thereby further enhancing user convenience and safety of the elevator.

To summarize such a failure prediction method, a process of inputting failure treatment results including faulty component and error code data to the maintenance terminal 600 may be performed first (S10), as shown in FIG. 12. Thereafter, the failure treatment results input to the maintenance terminal 600 may be collected and stored by the failure diagnosis server 500 (S20). The failure diagnosis server 500 may predict a possible future faulty component and a future failure occurrence time through application of the stored failure treatment results together with failure occurrence time data to a machine learning model (S30). Thereafter, the maintenance terminal 600 may receive the failure prediction results of the failure diagnosis server 500 and display the failure prediction results on a screen (S40).

Here, in the step S20 of collecting and storing the failure treatment results through the failure diagnosis server 500, the failure treatment results may be collected from the maintenance terminal 600, and the collected failure treatment results may be classified for each faulty component and sequentially stored in the treatment result storage unit 510 in a time sequence of failure occurrence.

The step of predicting the failure occurrence time (S30) may include calculating a failure occurrence time interval for each faulty component stored in the treatment result storage unit 510 (S31), and predicting a future failure occurrence time for each faulty component through application of each faulty component, the error code data, and the failure occurrence time interval for each faulty component stored in the treatment result storage unit 510 to a machine learning model (S32). The step (S30) of predicting the failure occurrence time may be performed through the calculation unit 520.

Although it has been described above that the calculation unit 520 of the failure diagnosis server 500 predicts a possible future failure for each component based on the failure treatment results input to the maintenance terminal 600, the calculation unit 520 may predict the possible future failure for each component based on the diagnosis result of the diagnosis unit 503 in another embodiment of the present invention.

As described above, the failure diagnosis server 500 may include the error code storage unit 502. The error code storage unit 502 may be configured to store the error code data collected from the control panel of the elevator by classifying the error code data into one time-series data group at every preset reference time interval. The diagnosis unit 503 may be configured to analyze the corresponding error code data for each time-series data group stored in the error code storage unit 502 to diagnose a failure cause for the time-series data group.

Here, the calculation unit 520 may be configured to predict the possible future faulty component and the future failure occurrence time through application of the faulty component and the corresponding error code data produced as a failure cause through the diagnosis result of the diagnosis unit 503 together with failure occurrence time data to a machine learning model.

More specifically, the diagnosis unit 503 may extract a faulty component and error code data corresponding to the failure cause in the process of diagnosing the failure cause. The calculation unit 520 may collect all diagnostic results of the diagnosis unit 503 from historical data to calculate a failure occurrence time interval for each faulty component. In addition, based on the calculated result, the calculation unit 520 may predict a future failure occurrence time for each faulty component by applying each faulty component, the error code data and the failure occurrence time interval for each faulty component to a machine learning model. Such a failure prediction process of the calculation unit 520 may be the same as the failure prediction process based on the input data of the failure treatment results described above, except that the data based on the diagnosis result of the diagnosis unit 503 is used as training data to be applied to the machine learning model.

That is, the calculation unit 520 may predict the possible future faulty component and the future failure occurrence time based on the failure treatment result data input through the maintenance terminal 600, or may predict the possible future faulty component and the future failure occurrence time based on the diagnosis result data of the diagnosis unit 503.

As such, the calculation unit 520 may be configured to predict failure in two ways and may be configured to integrate the failure prediction results, for example, by averaging the failure prediction results, to produce a single failure prediction result. That is, the calculation unit 520 may integrate the failure prediction result based on the failure treatment results of the maintenance terminal 600 and the failure prediction result based on the diagnosis result of the diagnosis unit 503 to produce a single failure prediction result with respect to the possible future faulty component and the future failure occurrence time.

By predicting a possible future failure based on these two kinds of data, it is possible to produce more accurate failure predictions.

In particular, since the diagnosis unit 503 of the failure diagnosis server 500 diagnoses a failure cause by reflecting the failure treatment results input from the maintenance terminal 600, accuracy of the failure cause diagnosis result of the diagnosis unit 503 is improved over time, thereby further improving the failure prediction result of the calculation unit 520 based on the diagnosis result of the diagnosis unit 503 over time.

Although some exemplary embodiments have been described herein, it should be understood that these embodiments are given by way of illustration only and that various modifications, variations, and alterations can be made by those skilled in the art without departing from the spirit and scope of the invention. Accordingly, it should be understood that the embodiments disclosed herein are intended to illustrate and not to limit the technical ideas of the invention, and the scope of the technical ideas of the invention is not limited by the embodiments. The scope of protection of the invention shall be construed in accordance with the following claims and all technical ideas within the scope of equivalents thereto shall be construed to be included within the scope of the invention.

### <List of Reference Numerals>

100: Elevator control panel
200: Communication unit
310: Modem
320: Surveillance server
400: Central management server
500: Failure diagnosis server
501a: First communication unit
501b: Second communication unit
502: Error code storage unit
503: Diagnosis unit
504: Failure cause storage unit
505: Failure cause update unit
510: Treatment result storage unit
520: Calculation unit
600: Maintenance terminal
601: Terminal communication unit
602: Display unit
603: Input unit
604: Controller
610: First output screen
611: Error code display region
612: Diagnosis result display region
613: Diagnosis result request input button
690: Treatment result input screen
691: Basic data input screen
692: Selection input screen
693: Component selection input screen
6931: Large classification selection button
6932: Faulty part selection button
6933: Faulty component selection button
694: Additional selection input screen
6941: Additional failure cause selection button
6942: Additional failure subject selection Button
6943: Additional treatment operation selection button
695: Error code selection input screen
6951: Error code selection button

## Claims

1. A maintenance system for passenger transport equipment, comprising:
a maintenance terminal carried by a maintenance worker and configured to input failure treatment results including faulty component and error code data after completion of failure treatment; and
a failure diagnosis server configured to collect and store the failure treatment results input from the maintenance terminal and configured to predict a possible future faulty component and a future failure occurrence time through application of the stored failure treatment results together with failure occurrence time data to a machine learning model,
wherein the maintenance terminal is configured to receive and display a failure prediction result sent from the failure diagnosis server.

2. The maintenance system according to claim 1, wherein the failure diagnosis server comprises:
a treatment result storage unit configured to collect and store the failure treatment results together with the failure occurrence time data; and
a calculation unit configured to predict the possible future faulty component and the future failure occurrence time through application of the faulty component and error code data of the failure treatment results and failure occurrence time data of each faulty component to the machine learning model.

3. The maintenance system according to claim 2,
wherein the treatment result storage unit is configured to classify the failure treatment results collected from the maintenance terminal for each faulty component and configured to sequentially store the failure treatment results in a time sequence of failure occurrence, and
wherein the calculation unit is configured to calculate a failure occurrence time interval for each faulty component stored in the treatment result storage unit and configured to predict a future failure occurrence time for each faulty component through application of each faulty component and error code data and the failure occurrence time interval for each faulty component to a machine learning model.

4. The maintenance system according to claim 2,
wherein the failure diagnosis server is configured to collect and store error code data of the passenger transport equipment from a control panel of the passenger transport equipment and configured to diagnose a failure cause based on the collected error code data, and
wherein the maintenance terminal is configured to access the failure diagnosis server to receive and display the error code data and a diagnosis result of the failure cause sent from in the failure diagnosis server.

5. The maintenance system according to claim 4, wherein the failure diagnosis server further comprises:
an error code storage unit configured to arrange and store the error code data of the passenger transport equipment collected from the control panel of the passenger transport equipment in a time sequence and configured to classify the error code data into one time-series data group at every preset reference time interval to store the classified error code data; and
a diagnosis unit configured to analyze the corresponding error code data for each time-series data group stored in the error code storage unit to diagnose a failure cause for the time-series data group,
wherein the calculation unit is configured to predict the possible future faulty component and the future failure occurrence time by applying a faulty component, corresponding error code data and failure occurrence time data produced based on the diagnosis result of the diagnosis unit to a machine learning model.

6. The maintenance system according to claim 5, wherein the calculation unit is configured to integrate a failure prediction result based on the failure treatment results of the maintenance terminal and a failure prediction result based on the diagnosis result of the diagnosis unit to produce a single failure prediction result with respect to the possible future faulty component and the future failure occurrence time.

7. A method of controlling a maintenance system for passenger transport equipment, the maintenance system including a maintenance terminal and a failure diagnosis server, the method comprising:
inputting failure treatment results including faulty component and error code data to the maintenance terminal;
collecting and storing the failure treatment results input to the maintenance terminal through the failure diagnosis server;
predicting a possible future faulty component and a failure occurrence time through the failure diagnosis server through application of the failure treatment results stored in the failure diagnosis server together with failure occurrence time data to a machine learning model; and
receiving and displaying a failure prediction result of the failure diagnosis server through the maintenance terminal.

8. The method of controlling a maintenance system for passenger transport equipment according to claim 7,
wherein the step of collecting and storing through the failure diagnosis server comprises: collecting the failure treatment results from the maintenance terminal; and classifying the collected failure treatment results for each faulty component to sequentially store the failure treatment results in a time sequence of failure occurrence, and
wherein the step of predicting through the failure diagnosis server comprises: calculating a failure occurrence time interval for each faulty component stored in the failure diagnosis server; and predicting a future failure occurrence time for each faulty component by applying each faulty component, the error code data and the failure occurrence time interval for each faulty component stored in the treatment result storage unit to a machine learning model.
